(19) Europäisches Patentamt
European Patent Office
Office européen des brevets

(11) **EP 3 563 161 B1**

(12) **EUROPEAN PATENT SPECIFICATION**

(45) Date of publication and mention
of the grant of the patent:
**26.07.2023 Bulletin 2023/30**

(21) Application number: **17826518.7**

(22) Date of filing: **22.12.2017**

(51) International Patent Classification (IPC):
**G01R 21/133** $^{(2006.01)}$    **G01R 22/10** $^{(2006.01)}$

(52) Cooperative Patent Classification (CPC):
**G01R 21/133; G01R 22/10**

(86) International application number:
**PCT/EP2017/084360**

(87) International publication number:
**WO 2018/122160 (05.07.2018 Gazette 2018/27)**

(54) **ELECTRICITY METER WITH AN IMPEDANCE LEARNING ALGORITHM**

ELEKTRIZITÄTSZÄHLER MIT IMPEDANZLERNALGORITHMUS

MESURE D'ÉLECTRICITÉ AU MOYEN D'ALGORITHME D'APPRENTISSAGE D'IMPÉDANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.12.2016 EP 16207560**

(43) Date of publication of application:
**06.11.2019 Bulletin 2019/45**

(73) Proprietor: **Kamstrup A/S
8660 Skanderborg (DK)**

(72) Inventor: **KIRKEGAARD, Dennis
8850 Bjerringbro (DK)**

(74) Representative: **Plougmann Vingtoft a/s
Strandvejen 70
2900 Hellerup (DK)**

(56) References cited:
US-A- 6 043 664    US-A1- 2003 014 200
US-A1- 2008 204 054    US-A1- 2012 191 440
US-A1- 2014 320 148    US-A1- 2016 072 270
US-B1- 6 397 156

• WEN FAN ET AL: "Intelligent data analysis for power systems", 2012 IEEE POWER AND ENERGY SOCIETY GENERAL MEETING ; SAN DIEGO, CALIFORNIA, USA; 22 - 26 JULY 2012, IEEE, PISCATAWAY, NJ, 22 July 2012 (2012-07-22), pages 1-8, XP032465590, DOI: 10.1109/PESGM.2012.6344953 ISBN: 978-1-4673-2727-5

**Description**

FIELD OF THE INVENTION

The invention relates to an electricity meter, in particularly an electricity meter for measuring electricity consumption in polyphasic electricity systems, including high-precision meters for measuring electricity consumption of a user in an electricity supply network in connection with payment to the electricity provider for consumed electric energy.

BACKGROUND OF THE INVENTION

In an electricity distribution network supplying energy to a number of consumers, the electric energy provider needs to be able to measure the electric energy consumed by or delivered to the individual consumers. Each consumer has an electricity meter installed measuring the electric energy delivered to the connection point of the consumer.

The electrical network is usually divided in two levels, a transmission network level and a distribution network level. The transmission network is operated at high voltages above 60kV and the distribution network is operated below 60kV. Most consumers are connected to the distribution network at voltage below 10kV; the majority are in fact connected at low voltages below 1000V.

In the transmission network, the grid, i.e. cables, transformers generators etc. are well defined with known impedances, allowing the Transmission System Operator (TSO) to simulate load flows based on known parameters. Whereas, when looking at the distribution network often only parameters of main components are known. This makes it more difficult for the Distribution System Operator (DSO) to predict overload and system stability. When it comes to overload and faults, it is important to know the short circuit currents (SC-currents), which may occur during a fault.

Today, SC-currents are determined by calculations with input data from transformer-, radial- and service wire impedances. Alternatively, impedances for calculating SC-currents may be measured with special equipment installed near or at the point of supply. In the first instance, the SC-currents are based on theoretical measures only and the actual SC-currents may differ in case of incorrect input data. In the second instance, expensive and specialized equipment have to be installed and manual operated which is labor- and cost intensive and only provides momentary impedance data.

The document US2008204054 A1 discloses system for a real-time determination of the characteristic impedance of a length of a power line involving synchronised current and voltage measurements for at least two locations on the power line. The measurement data thus obtained are then fitted to a circuit model of the power line to obtain a characteristic impedance for the power.

Electricity meters of the prior art, have the drawback that they only provide the DSO with information about voltages, currents, and power consumption at the point of use. An object of the present invention is to provide a cost-effective electricity meter providing additional information about impedances of the electricity distribution network as seen by the electricity meter.

SUMMARY OF THE INVENTION

According to a first aspect of the present invention there is provided an electricity meter according to claim 1.

An advantage of the first aspect is that the electricity meter provides the impedance seen at the electricity meter, based on values already measured by it.

Further, as electricity meters are permanently installed in the distributions grid, information about impedances in the distributions grid are continuously obtained. In one embodiment, the impedance learning algorithm unit may be arranged to estimate the negative sequence impedance and the zero sequence impedance by using Least Square algorithms, especially minimum Least Square algorithms. An advantage in this regard is that the impedance is estimated by the ratio of two summations.

Furthermore, the impedance learning algorithm unit is arranged to approximate the zero sequence impedance by an auto-regressive (AR) process comprising a first forgetting factor, and to approximate the negative sequence impedance by another auto-regressive (AR) process comprising a second forgetting factor. An advantage of this implementation is that it minimizes the use of data memory in the electricity meter.

In another embodiment, the first- and second forgetting factors may be dynamical factors depending on the ratio of the changes in the sequence current to a summarized current change. An advantage of this embodiment is that the system is less sensitive to voltage noise from the grid.

Additionally, the summarized current change may be limited by a maximum measured current value of the electricity meter whereby small current changes has less weight than larger current changes.

Further, the electricity meter may include a low pass filter, arranged to filter out higher harmonics of the measured voltages and currents. By filtering out higher harmonics, the higher harmonics of negative sequence or positive sequence will have less effect on the impedance estimation.

In one embodiment, the voltage changes and current changes of the measurements are measured over a time interval of 5 to 30 seconds. Alternatively, the time interval may be 0,1-1 seconds or 15-30 milliseconds.

The electricity meter may also comprise a communication module arranged to transmit the impedance value to a data collector. By transmitting impedance values from a plurality of electricity meters installed in a distributions grid, information about impedances in the distributions grid are collected and can be used in a model of the distributions grid.

According to a second aspect of the present invention there is provided a method according to claim 12.

According to a third aspect of the present invention there is provided a system according to claim 13.

BRIEF DESCRIPTION OF DRAWINGS

In the following, the invention will be described in more details by referring to embodiments illustrated in the accompanying drawings, of which:

Figure 1 shows a block diagram of an electricity meter,
Figure 2 shows details of a measurement circuit of an electricity meter,
Figure 3 shows a classical system representation of a single installation along a distribution line,
Figure 4 shows a symmetrical system equivalent,
Figure 5 illustrates a system comprising a plurality of consumption meters and a data collector.

DETAILED DESCRIPTION

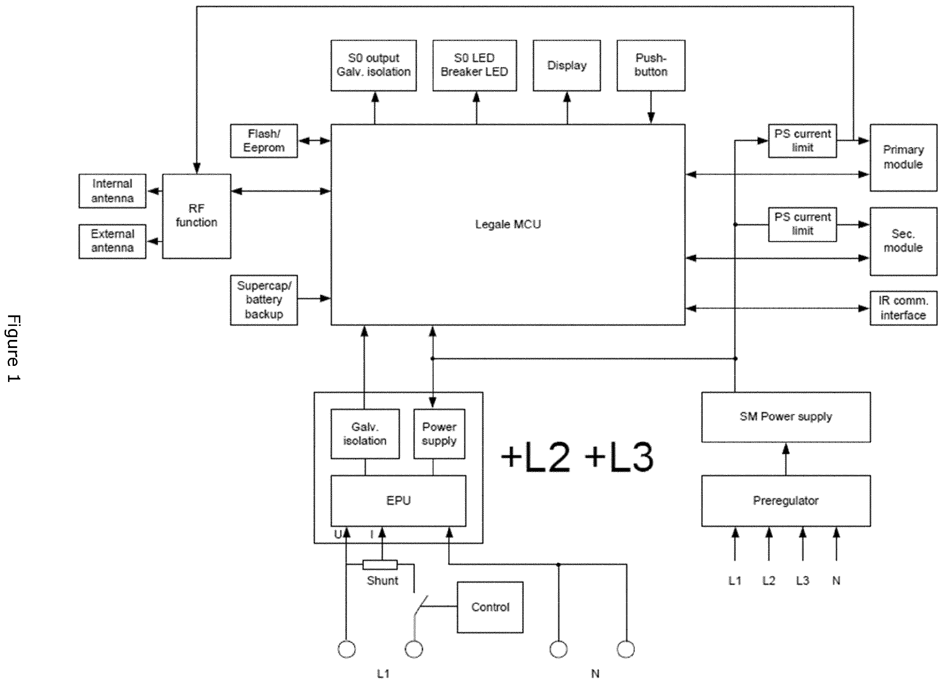

Referring to Fig. 1, an electricity meter 2 including an impedance learning algorithm (ILA) is illustrated. By including the ILA in the meter, impedances of the grid as seen by the meter can be continuously estimated thereby allowing for example continuously estimation of short circuit currents (SC-currents). This allows Distribution System Operators (DSOs) to monitor the condition of the low voltage (LV) distribution grid, without installation of additional equipment. By this, action can be taken by the DSO if the estimated impedances do not comply with the theoretical or former estimated impedances. Changing impedances could for example be a symptom of bad connections that may cause melt down or, in case of a broken neutral wire, an overvoltage situation with extensive damages to follow.

The purpose of the ILA is to estimate the impedance in front of the electricity meter, i.e. the impedance of the distribution grid between substations and the terminals (L1, L2, L3) of the meter.

Electrical impedance is the measure of the complex ratio of the voltage to the current in an alternating current (AC) circuit. The impedance therefore has two orthogonal vectors, where resistance forms the real part of complex impedance, and reactance forms the imaginary part of complex impedance.

The electrical grid comprises a plurality of consumers, distribution lines and generators or sources, all of which changes over time. The impedance of the grid as seen from each electricity meter therefore changes every time the configuration of the grid changes. Changes can be very small, when small loads and sub systems are connected, or large when larger loads and sub systems are connected. In a simple system, impedance is the resistance and reactance between the meter and the source, i.e. a generator, and the impedance measured at the electricity meter is the impedance seen by the meter from the terminals to the power source. However, in reality every single component of the electrical grid contributes to the impedance thus affecting the impedance seen by the meter. Therefore, the impedance estimated by the ILA is denoted the impedance value of the electrical grid as seen by the electricity meter.

In respect of SC-current, the measures maximum SC-current and minimum SC-current are of primary interest. The maximum SC-current determines the required grade of switching equipment at the point of supply and the minimum SC-current is used to calculate the energy deposing in cables in case of a critical short circuit failure between a live line and the neutral conductor. Improper dimensioning of the former, may cause explosion or fire in protection equipment during short circuit, whereas improper dimensioning of the latter, may cause cables to melt down before the fuses blow in case of a short circuit event. In Fig. 1, a block diagram illustrates the main elements of an electricity meter according to the invention. The electricity meter includes a microcontroller unit (Legal MCU), which handles the data processing of measured current and voltage values in order to sum the consumed power. The microcontroller unit also includes or is configured to execute the impedance learning algorithm, as will be further described in the following. The electricity meter measures voltages and currents for each of the three electrical phases (L1, L2, L3), to determine the total electricity consumption on the three phases. The neutral connection is denoted N and only the current measurement circuit for phase one (L1) is shown in detail, but the measurement circuits for phases L2 and L3 comprise identical features. The current signal is measured through a shunt resistor and send to an electronic processing unit (EPU). Further, a switch operated by a control block is included to open or close the measurement circuit thereby controlling the current flow through the shunt. The electronic processing unit is galvanically isolated from the microcontroller unit and fed by a power supply circuit.

As is readily understood by the skilled person, the present invention is not limited to embodiments where the current is measured using a shunt resistor. Other types of measurement circuits may also be implemented, such as measurement circuits including current transformers or Hall effect circuits.

The power supply includes a switch mode power supply (SM Power supply), connected to the electrical phases via a preregulator including of a rectifier circuit. The electricity meter further includes a communication module (RF function) and two antenna elements for communication of measurements and data such as estimated impedance values. The communication module is coupled to the calculating circuit in such a way that the measurements and any other data can be sent wirelessly through a wireless network to a data collector.

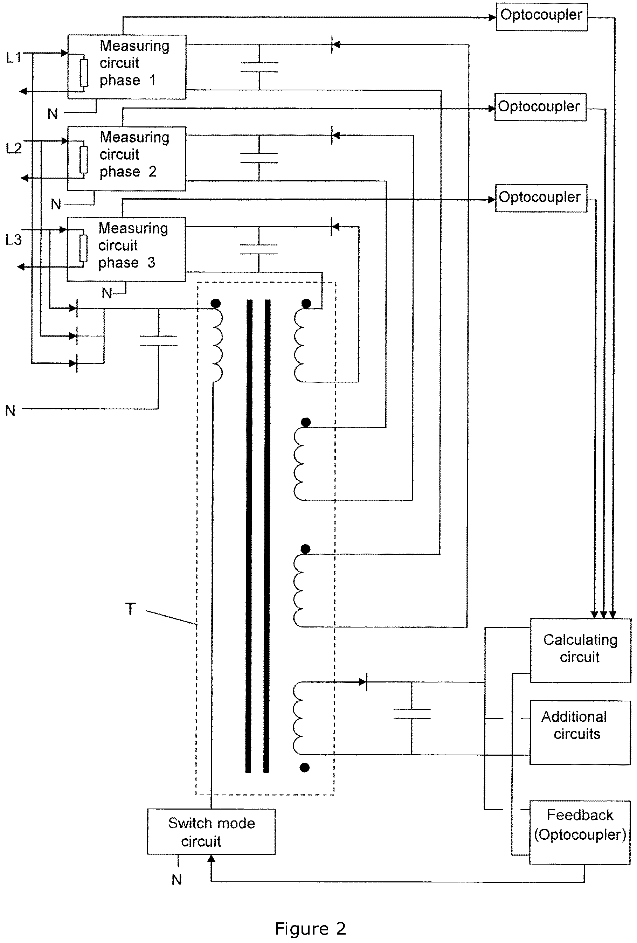

Fig. 2 shows the separate measuring circuits for each of the three phases (L1, L2, L3) configured to measure and calculate energy consumption and adapted to communicate the result, via an optocoupler, to a calculation circuit. The calculation circuit sums up the consumption data for each of the phases (L1, L2, L3) and calculates a total energy consumption. The separate measuring circuits are directly coupled to the three phases (L1, L2, L3) to measure the voltage of each phases. As the measuring circuits determine the current based on the shunt resistor principle, they are coupled directly to the voltage potential of each phase. Therefore, galvanic separation is provided between the power supply for each of the measurement circuits. For this purpose, the transformer T has separate secondary windings galvanically separated from each other for power supply of each of the measuring circuits.

Furthermore, calculating circuits, additional circuits and feedback (optocoupler) for the switch mode circuit in the switch mode voltage supply are supplied with voltage from an additional secondary winding of the transformer T. This secondary winding being galvanically separated from the secondary windings for the supply to the measuring circuits.

The primary winding of the transformer T is charged with energy from a coupled switch mode circuit operating with a switch frequency of preferably 100 kHz or more. As may be seen, the switch mode circuit is connected to the primary winding of the transformer, and the primary winding is connected to the different phases (L1, L2, L3) via diodes in a way allowing the switch mode circuits and the calculating circuits to be supplied when only a potential is present on one of the three phases (L1, L2, L3).

The electrical voltages and currents measured at the electricity meter contains all the harmonics present in the network, only limited by the bandwidth of the measurement system. Measuring electrical power, higher harmonics should be included, as they are also obtained by the consumer. On the other hand, higher harmonics such as 5th, 7th 11th and 13th may be seen as disturbances when using the voltages and currents to estimate other values, such as impedances. Low pass filtering of the signals may therefore be advantageous. Such filtering can be achieved with analogue filters prior to measurement. However, if only one set of measurements are used, i.e. the same set of measurements are used for both calculating power consumption and for estimating impedances, the power measurements lack the contribution from the higher harmonics. Therefore, digital filtering may be preferred and in one embodiment, voltage and current signals are digitally low pass filtered prior to impedance estimation.

The impedances in a distribution grid can be described by symmetrical components, i.e. the positive sequence impedance($Z_1$), the negative sequence impedance ($Z_2$) and the zero sequence impedance ($Z_0$), known to the skilled person. By the nature of symmetrical components, the positive-, negative- and zero sequences does not affect each other and may be estimated independently. Additionally, the positive and negative sequence impedances in transformers and distribution systems are mainly equals. By this, is possible to estimate the positive sequence impedance by the negative sequence impedance, which is advantageous as the negative sequence component is easier to estimate than the positive sequence component.

Referring back to the higher harmonics, some of them belongs to negative sequence components, some to positive sequence components and some to the zero sequence components. Harmonics such as the 5th and 11th, which "rotate" in the opposite sequence as the fundamental, are negative sequence components. Harmonics such as the 7th and 13th, which "rotate" with the same sequence as the fundamental, are positive sequence components. Triplen harmonics (3r and 9th) which do not "rotate" as they are in phase with each other are zero sequence components. In a symmetrical 3 phase system triplen harmonics are not present, but in systems where the loads in the households or the like often are single phase and often non-linear, the triplen will be present. An example of a non-linear single phase components is low energy fluorescent lights. The pattern of positive-zero-negative-positive continues indefinitely for all odd-numbered harmonics, but the higher the number of harmonic, the lower the content are present in the electrical grid. Harmonics comes from non-linear loads in the grid. The 5th, 7th, 11th and 13th harmonics often come from electrical machines, both generators and motors. The content of each of the harmonics differ and the level of 5th harmonic is rarely the same as the level of 7th harmonic. This means that the 5th harmonics is added to the negative sequence components and the 7th harmonics will be added to the positive sequence components. In electrical grids with high level of harmonic content and especially with a large difference between harmonics of positive sequence and harmonics of negative, the assumption that the negative and positive sequences are equal may become false. In such networks, low pass filtering of the signals may be beneficial to the accuracy of impedance estimations.

In the following, the symmetrical components are explained further. Zero sequence components will be noted by the subfix-0 (zero), positive sequence components by the subfix-1 (one) and negative sequence components by the subfix-2. The traditional phase components related to the voltage and current measurements at the three phases will be denoted by subfix-a, -b and -c.

In the transform between normal and symmetrical components, the complex size operator *a,* denoting the 120-degree phase shift, is used:

$$a = e^{i\frac{2\pi}{3}} = \cos(120°) + i\sin(120°)$$

Using the below transformation matrix, T:

$$T = \begin{bmatrix} 1 & 1 & 1 \\ 1 & a^2 & a \\ 1 & a & a^2 \end{bmatrix}$$

$$T^{-1} = \frac{1}{3}\begin{bmatrix} 1 & 1 & 1 \\ 1 & a & a^2 \\ 1 & a^2 & a \end{bmatrix}$$

The relationship between normal/traditional components and symmetrical components are as follows:

$$V_{abc} = TV_{012}$$

and

$$V_{012} = T^{-1}V_{abc}$$

Above the transformation to symmetrical components are shown for the voltage components, however the symmetrical current components are calculated using the same transformation matrix. The transformation of impedances into symmetrical components is as follows:

$$Z_{012} = T^{-1}Z_{abc}T$$

For transmission lines with balanced impedances, the special case appears that the symmetrical impedance matrix is diagonal:

$$Z_{012} = \begin{bmatrix} Z_0 & 0 & 0 \\ 0 & Z_1 & 0 \\ 0 & 0 & Z_2 \end{bmatrix}$$

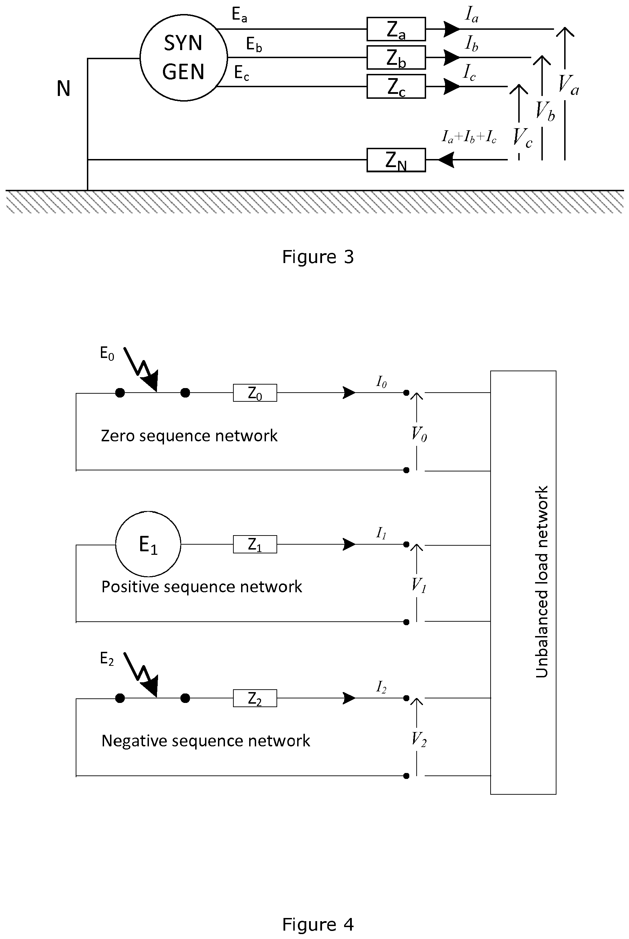

Referring to Fig. 3 a classical system representation of a single grid installation is shown. The installation includes a power generation unit (SYN GEN) along a distribution line having a three-phase output ($E_a$, $E_b$, $E_c$). The power generation unit is a synchronous generator (alternatively, it could be a Delta-wye coupled transformer). The installation is further characterized by a set of balanced line impedances ($Z_a$, $Z_b$, $Z_c$), some measures of unbalanced currents ($I_a$, $I_b$, $I_c$) and voltages ($V_a$, $V_b$ $V_c$) to the installation at the end of the distribution line. These are the impedances an electricity meter sees in a simple electrical grid.

Fig. 4 shows a symmetrical system equivalent to the system of Figure 3, including a zero sequence- a positive sequence, and a negative sequence network. The generator is changed to a symmetrical positive sequence generator $E_1$, which drives the positive sequence current $I_1$ through the positive sequence line impedance $Z_1$ and into an unbalanced load network (the end user's installation), which may distribute the current through the negative- or zero sequence impedances depending on the load configuration, especially in case of unbalanced loading.

As elucidated above, positive, negative and zero sequence currents ($I_0$, $I_1$, $I_2$) and voltages ($V_0$, $V_1$, $V_2$) may be calculated based on the unbalanced currents ($I_a$, $I_b$, $I_c$) and voltages ($V_a$, $V_b$ ,$V_c$) measured by the meter, according to below equations:

$$V_{012} = T^{-1}V_{abc}$$

$$I_{012} = T^{-1}I_{abc}$$

However, in the real world the precise magnitude of $E_1$ will be unknown. Further, the degree of balance is not guaranteed but is assumed static for short time frames. The unbalanced nature of the power generator and grid-induced disturbances are illustrated with sparks ($E_0$ and $E_2$) in the zero- and negative sequence networks shown in Fig. 4.

The zero sequence-, positive sequence, and negative sequence networks can each be individually identified. To this end, we use the equation for voltage drop over the symmetrical impedance (Here shown only for the negative sequence network, but identical equations apply to the positive- and the zero sequence networks):

$$E_2 - V_2 = I_2 Z_2$$

To identify the symmetrical impedance the change in load current is monitored to identify what change in voltage measurement it causes. For this, we define a period at where $E$ is assumed to be mainly static, such as a period of 5-10 seconds. The value changes within this period is denoted by capital Delta, $\Delta$ and by rearranging, we get the following expression for the negative sequence:

$$Z_2 - \frac{\Delta E_2}{\Delta I_2} = -\frac{\Delta V_2}{\Delta I_2}$$

Assuming the injected voltage $E_2$ to be mainly static, we get the following expression for the negative sequence impedance:

$$Z_2 \approx -\frac{\Delta V_2}{\Delta I_2}$$

A similar simplified expression could be elucidated for the zero sequence network. However, as the positive sequence network includes the generator the injected voltage can only be assumed static for a very short period making it practically impossible to determine the positive sequence impedance based on above simplified expression. However, as the transmission line impedances are assumed balanced, the positive- and negative sequence networks have equal impedances and the positive sequence impedance ($Z_1$) may be estimated from the negative sequence impedance ($Z_2$). Based on the above we get the following:

$$Z_1 = Z_2 \approx -\frac{\Delta V_2}{\Delta I_2}$$

$$Z_0 \approx -\frac{\Delta V_0}{\Delta I_0}$$

To identify the zero sequence impedance ($Z_0$) and the negative sequence impedance ($Z_2$). Minimum least square (MLS) techniques may be applied on time series of delta values, i.e. voltage changes and current changes. These time series might not be continuous time series but must be composed based on change in the load network.

In the following, further details of the impedance learning algorithm (ILA) will de described. The ILA starts by converting the voltage and current measurements for each time interval into the corresponding zero- and negative sequence components:

$$\begin{bmatrix} V_0 \\ V_2 \end{bmatrix} = \frac{1}{3} \begin{bmatrix} 1 & 1 & 1 \\ 1 & a^2 & a \end{bmatrix} \begin{bmatrix} V_a \\ V_b \\ V_c \end{bmatrix} = \boldsymbol{V_{02}}$$

$$\begin{bmatrix} I_0 \\ I_2 \end{bmatrix} = \frac{1}{3}\begin{bmatrix} 1 & 1 & 1 \\ 1 & a^2 & a \end{bmatrix}\begin{bmatrix} I_a \\ I_b \\ I_c \end{bmatrix} = \boldsymbol{I_{02}}$$

Next, a load admittance for each phase is calculated:

$$\begin{bmatrix} Y_a \\ Y_b \\ Y_c \end{bmatrix} = \begin{bmatrix} I_a/V_a \\ I_b/V_b \\ I_c/V_c \end{bmatrix} = \boldsymbol{Y_{abc}}$$

and the level of change of the load admittance is determined:

$$\Delta Y_{abc}(n) = Y_{abc}(n) - Y_{abc}(n-1),$$

The level of change of the load admittance is included in the ILA to control which current and voltage changes to include in the impedance estimation. The level of change could be based on a simple threshold analysis of the phase admittances changes. Otherwise, the load admittances may be converted into symmetrical components and the decision to proceed may then depend on the change of current "injection" from the positive sequence system into the zero sequence- and negative sequence systems.

When a certain change in the load admittances has been achieved, e.g. 4.348mS equivalent to approx. 1A at 230V, the algorithm proceeds with the calculation of the deltas of the symmetrical voltage- and current components:

$$\Delta V_{02}(n) = V_{02}(n) - V_{02}(n-1)$$

$$\Delta I_{02}(n) = I_{02}(n) - I_{02}(n-1)$$

The correlation between the time series of these deltas is determined by the symmetrical impedance matrix without the positive sequence component:

$$Z_{02} = \begin{bmatrix} Z_0 & 0 \\ 0 & Z_2 \end{bmatrix}$$

$$-\Delta \bar{V}_{02} = Z_{02}\Delta \bar{I}_{02}$$

and because the symmetrical impedance matrix $Z_{02}$ is assumed diagonal, two independent systems, with respectively the zero- and negative sequence impedances as correlation constants, can be defined:

$$-\Delta \bar{V}_0 = Z_0 \Delta \bar{I}_0$$

$$-\Delta \bar{V}_2 = Z_2 \Delta \bar{I}_2$$

Solving the two independent systems in a least squares sense is done by the following matrix manipulation (omitting the deltas, numbers and bars for simplicity):

$$Z = -VI^H(II^H)^{-1}$$

By the dimensionality of one for each sample, each system is defined by below equation showing that the impedance can be estimated as the ratio between two summations:

$$Z = -\frac{\sum VI^*}{\sum |I|^2}$$

In one embodiment of the ILA, the number of samples summarize could be infinite, providing an all-time best estimate of the impedance. However, to prevent numerical saturation and as the impedance may change slowly over time, due to reconfigurations of the grid, it may be advantageous to limit the summation to a certain interval ($\alpha$), i.e. limit the summation to a predetermined number of samples:

$$Z(n) = -\frac{\sum_{i=n-\alpha}^{n} V(i)I^*(i)}{\sum_{i=n-\alpha}^{n} |I(i)|^2}$$

The above definition of a limited summation could alternatively de defined by two moving average finite impulse response (FIR) filters of degree alpha ($\alpha$):

$$Z(n) = -\frac{\frac{1}{\alpha+1}\sum_{i=n-\alpha}^{n} V(i)I^*(i)}{\frac{1}{\alpha+1}\sum_{i=n-\alpha}^{n} |I(i)|^2}$$

In an alternative embodiment, to save memory for storing current and voltage data in case of large intervals, the moving average MA($\alpha$) processes may be approximated by an auto-regressive (AR) processes with a forgetting factor ($\rho$), resulting in the below definition of the impedance (still omitting the deltas):

$$Z(n) = \frac{Z_{num}(n)}{Z_{den}(n)}$$

$$Z_{num}(n) = (1-\rho)Z_{num}(n-1) + \rho V(n)I^*(n)$$

$$Z_{den}(n) = (1-\rho)Z_{den}(n-1) + \rho |I(n)|^2$$

In the above defined auto-regressive process, the forgetting factor ($\rho$) is a static number determining the weight of new sample-sets compared to the accumulated result of previous samples. In some implementations, this may be undesirable, as it gives small current changes, the same weight in the process as the larger current changes, thereby making the system more sensitive to voltage noise from the grid. To improve the performance of the ILA the forgetting factor may be defined as a dynamic factor based on the ratio of a present current change to a summarized current change up to a certain limit of current, as defined below:

$$\rho(n) = \frac{|\Delta I(n)|}{\min(\sum_n |\Delta I(n)|\, ; A)}$$

Here capital alpha (A) is an upper limit for summarizing current change stored in a memory of the electricity meter, e.g. 15kA (15,000 ampere). Based on the above the ILA may be defined by:

$$Z(n) = \frac{Z_{num}(n)}{Z_{den}(n)}$$

$$Z_{num}(n) = \left(1-\rho(n)\right)Z_{num}(n-1) + \rho(n)\Delta V(n)\Delta I^*(n),$$

$$Z_{den}(n) = \big(1 - \rho(n)\big)Z_{den}(n-1) + \rho(n)|\Delta I(n)|^2$$

The above algorithm for estimating impedance is run by the microcontroller unit based on measured currents and voltages to estimate both the zero sequence impedance ($Z_0$) and the negative sequence impedance ($Z_2$). The zero- and negative sequence impedances are thus estimated based on the ratio between $Z_{num}$ and $Z_{den}$, being a ratio between a summation of changes in the voltage components and a summation of changes in the current components wherein both summations are continuously updated in an adjustable auto-regressive (AR) process.

As previously described, it is important to know the impedances of a distributed network to be able to modulate the network for simulation purposes. A valid model of the distribution network will allow the DSO to detect faults and contingency risks before they cause problems. In this regard, impedance values estimated by a single electricity meters may be of limited value, whereas the collection of impedance values from an entire population of electricity meters may provide the DSO with sufficient information to make a valid model of a distribution network. Being able to collect impedance value from individual electricity meter, each electricity meter being a node in the network model, thus may be advantageous.

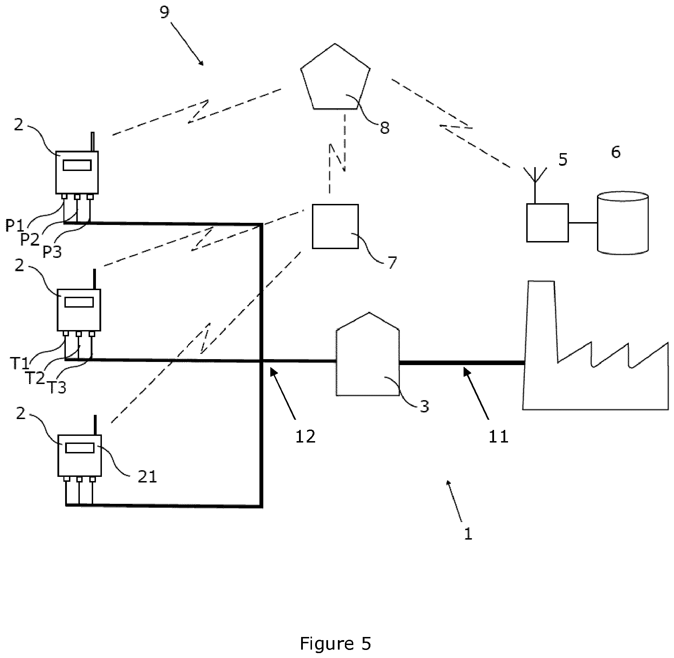

Referring to Fig. 5, a system including a plurality of electricity meters 2 as described above, is shown. Each meter is connected to the three phases (P1, P2, P3) of the electricity network and configured to measure currents and voltages associated with each phase. By processing the measured currents and voltages in a processor 21 (previously referred to as the microcontroller unit) of the electricity meter, meter data such as impedance, power consumption etc. is derived. The electricity meters thus estimates the impedance value seen at the measurement terminals of the meter (L1, L2, L3, and N). The electrical power measured at the meters 2 is supplied from a power plant 10, and send via a transmission network 11 to a substation 3, which sends the power through an electricity distribution network 12.

Still referring to Fig. 5, the system further comprises a network of data collectors, here in the form of sub-collectors 7 and main collectors 8. The main collector is connected to a backend system 5 of the utility provider and the sub-collector is a concentrator unit arranged as a concentrator node to collect meter data from a group of consumption meters. The total network may advantageously be a radio network, however at least the network between the concentrators and the electricity meters are a radio network, whereas the link between the collectors and the backend system may be of any suitable type. The number of consumption meters in the system may range from a few hundreds to several thousands of meters connected in the network. Each of the electricity meters are thus wirelessly connected 9 to the data collectors thereby creating a communication network for transmitting estimated meter data, including impedance value to the data collectors. From the main collectors 8 the meter data is transmitted to a backend system 5 and stored in an associated server 6.

To ensure a network where all nodes (i.e. the consumption meters and other network devices) are connected to provide a communication path between each electricity meter and the main collector, a rather complex network may be created, in particular in residential areas. For example, a meter 2 may be connected to the main collector 8 via direct connection to the concentrator 7; such a meter may be referred to as a zero level meter. In a real large-scale network, a large number of high-level meters may also be found. Such networks may also be referred to as a multi-hop network. However, generally the network is a hybridized network based on a number of basic topologies, including but not limited to point-to-point, star, tree and mesh as the important topology types.

Furthermore, a valid network model as discussed above may allow the DSO to detect unexpected behaviour in the distribution network, such as tampering with the electricity meters, i.e. the local electricity network of the consumer, which is monitored by the electricity meter. To this end, the plurality of electricity meters of the system may provide impedance information to establish a network model. The network model is then used to simulate the distribution network, and thereby provide information about short circuit levels and load flow issues. Further, it can also be used to detect irregularities in the electrical power fed into the distribution network compared to the consumed power measured by the electricity meters. By combining current and voltage measurements with impedance estimations, more precise information about the specific location of the potential meter tampering may be achieved. In this regard, impedance value from single meters may be used to detect local grid issues such as cable degradation, which often leads to cable faults.

Furthermore, the electricity meters may be equipped with a unit to receive GPS based time signals. Having a large number of nodes, i.e. meters, in the network model, each with an impedance value and a time stamp from the GPS signal, will furthermore allow the DSO to include phase values in the model and thereby get an even better model of the network. However, as meters with GPS unit are expensive, a good compromise may be a meter that can estimate impedance without a GPS time signal. In this regard, a system including a combination of electricity meters with GPS units and electricity meters without GPS units may be envisaged. The meters with GPS units may be installed at key nodes in the network, where it is important to receive precise phase values and the remaining nodes may be provided with meters for estimating impedance values without GPS units.

**Claims**

1.  An electricity meter (2) adapted to measure electricity consumption in an electricity distribution network (12) with three phases (L1, L2, L3), the electricity meter comprising:

    - a measuring circuit for measuring voltages and currents for each of the three phases,
    - a microcontroller unit (MCU) configured to calculate the electric energy supplied from the electricity distribution network via the phases, and
    - an impedance learning algorithm unit for being executed by the microcontroller unit, being arranged to estimate impedance values of the electricity distribution network as seen at the electricity meter, wherein the impedance learning algorithm unit is arranged to:

    - based on measured voltages and currents from the three phases, continuously calculate values of zero sequence and negative sequence voltages ($V_0$, $V_2$) and values of zero sequence and negative sequence currents ($I_0$, $I_2$)

    **characterized in**

    - estimating a zero sequence impedance ($Z_0$) as the ratio between a summation of changes in the zero sequence voltage ($\Delta V_0$) and a summation of the changes in the zero sequence current ($\Delta I_0$),
    - estimating a negative sequence impedance ($Z_2$) as the ratio between a summation of changes in the negative sequence voltage ($\Delta Vz$) and a summation of changes in the negative sequence current ($\Delta I_2$) wherein the summations of changes in zero- and negative sequence voltages and currents are continuously updated in an adjustable auto-regressive process and wherein the auto-regressive process for estimating the zero sequence impedance ($Z_0$) comprises a first forgetting factor ($\rho_0$), and the auto-regressive processes for estimating the negative sequence impedance ($Z_2$) comprises a second forgetting factor ($\rho_2$).

2.  The electricity meter according to claim 1, the impedance learning algorithm unit further being arranged to estimate the negative sequence impedance ($Z_2$) and the zero sequence impedance ($Z_0$) by using Least Square algorithms, especially minimum Least Square algorithms.

3.  The electricity meter according to any of the preceding claims, wherein the zero sequence impedance ($Z_0$) is estimated as the ratio between a summation of changes in the zero sequence voltage ($\Delta V_0$) multiplied by a factor and a summation of the changes in the zero sequence current ($\Delta I_0$) multiplied by a factor, and wherein the negative sequence impedance ($Z_2$) is estimated as the ratio between a summation of changes in the negative sequence voltage ($\Delta Vz$) multiplied by a factor and a summation of the changes in the negative sequence current ($\Delta I_2$) multiplied by a factor.

4.  The electricity meter according to claim 3, wherein the factor is derived from the changes in the zero- or the negative sequence currents, respectively.

5.  The electricity meter according to any of claims 1-4, wherein the first forgetting factor ($\rho_0$), and second forgetting factor ($\rho_2$) are dynamical factors depending on the ratio of the changes in the sequence currents ($\Delta I_0$, $\Delta I_2$) to a summarized current change.

6.  The electricity meter according to claim 5, wherein the summarized current change is limit by a maximum measured current value of the electricity meter.

7.  The electricity meter according to claim 6, wherein each of the zero- and negative sequence impedances are estimated by:

$$Z(n) = \frac{(1-\rho(n))Z_{num}(n-1)+\rho(n)\Delta V(n)\Delta I^*(n)}{(1-\rho(n))Z_{den}(n-1)+\rho(n)|\Delta I(n)|^2} \, ,$$

wherein the forgetting factor ($\rho$) is a dynamic factor defined as:

$$\rho(n) = \frac{|\Delta I(n)|}{\min(\sum_n |\Delta I(n)|; A)} \ .$$

8. The electricity meter according to any of the preceding claims, further comprising a low pass filter, arranged to filter out higher harmonics of the measured voltages and currents.

9. The electricity meter according to any of the preceding claims, further comprising a unit to receive a GPS time signal.

10. The electricity meter according to any of the preceding claims, wherein the voltage changes and current changes of the measurements are measured over a time interval of 5 to 30 seconds.

11. The electricity meter according to any of the preceding claims, wherein the electricity meter comprises a communication module arranged to transmit the impedance value to a data collector.

12. Method for estimating grid impedance in a distribution network with three phases, the method comprising:

- measuring voltages and currents for each of the three phases, so to calculate the electric energy for each phase supplied from the electricity distribution network;
- estimating an impedance value of the electrical grid by an impedance learning algorithm, wherein the impedance learning algorithm comprises:

- calculating zero sequence components and negative sequence components, including zero- and negative sequence voltages and currents, of the three phases, based on measured voltages and currents;

**characterized in**

- estimating a zero sequence impedance as the ratio between a summation of changes in the zero sequence voltage and a summation of the changes in the zero sequence current, wherein the summations of changes are continuously updated in an adjustable auto-regressive process; and
- estimating a negative sequence impedance as the ratio between a summation of changes in the negative sequence voltage and a summation of changes in the negative sequence current, wherein the summations of changes are continuously updated in an adjustable auto-regressive process and
- wherein the auto-regressive process for estimating the zero sequence impedance ($Z_0$) comprises a first forgetting factor ($\rho_0$), and the auto-regressive processes for estimating the negative sequence impedance ($Z_2$) comprises a second forgetting factor ($\rho_2$).

13. A system including a plurality of electricity meters according to claims 1 to 11 each being arranged for measuring electricity data of a supplied utility and a data collector for collecting the electricity data, including impedance values, the electricity meters and the data collector being arranged as data nodes in a communication network; wherein the electricity data, including impedance values, are being used to form a network model of the electricity distribution network of the plurality of electricity meters; the network model of the electricity distribution network, providing information about the electricity distribution network; and wherein a distribution system operator operates the system according to the network model.

**Patentansprüche**

1. Elektrizitätszähler (2), der dazu ausgelegt ist, einen Elektrizitätsverbrauch in einem Elektrizitätsverteilungsnetz (12) mit drei Phasen (L1, L2, L3) zu messen, wobei der Elektrizitätszähler Folgendes umfasst:

- eine Messschaltung zum Messen von Spannungen und Strömen für jede der drei Phasen,
- eine Mikrosteuerungseinheit (MCU), die dazu konfiguriert ist, die über die Phasen von dem Elektrizitätsverteilungsnetz gelieferte elektrische Energie zu berechnen, und
- eine Impedanzlernalgorithmuseinheit zur Ausführung durch die Mikrosteuerungseinheit, die dazu eingerichtet ist, Impedanzwerte des Elektrizitätsverteilungsnetzes, wie sie an dem Elektrizitätszähler zu sehen sind, zu schätzen, wobei die Impedanzlernalgorithmuseinheit für Folgendes eingerichtet ist:

- auf Grundlage der gemessenen Spannungen und Ströme von den drei Phasen kontinuierlich Werte von Null- und Gegenspannung ($V_0$, $V_2$) und Werte von Null- und Gegenstrom ($I_0$, Iz) zu berechnen,

**gekennzeichnet durch**

- Schätzen einer Nullimpedanz ($Z_0$) als das Verhältnis zwischen einer Summe von Änderungen der Nullspannung ($\Delta V_0$) und einer Summe der Änderungen des Nullstromes ($\Delta I_0$),
- Schätzen einer Gegenimpedanz ($Z_2$) als das Verhältnis zwischen einer Summe von Änderungen der Gegenspannung ($\Delta$Vz) und einer Summe von Änderungen des Gegenstroms ($\Delta I_2$),
wobei die Summen von Änderungen von Null- und Gegenspannung und - strom in einem einstellbaren autoregressiven Prozess kontinuierlich aktualisiert werden und
wobei der autoregressive Prozess zum Schätzen der Nullimpedanz ($Z_0$) einen ersten Vergessensfaktor ($\rho_0$) umfasst und die autoregressiven Prozesse zum Schätzen der Gegenimpedanz ($Z_2$) einen zweiten Vergessensfaktor ($\rho_2$) umfassen.

2. Elektrizitätszähler nach Anspruch 1, wobei die Impedanzlernalgorithmuseinheit ferner dazu eingerichtet ist, die Gegenimpedanz ($Z_2$) und die Nullimpedanz ($Z_0$) unter Verwendung von Algorithmen des kleinsten Quadrats, insbesondere von minimalen Algorithmen des kleinsten Quadrats, zu schätzen.

3. Elektrizitätszähler nach einem der vorhergehenden Ansprüche, wobei die Nullimpedanz ($Z_0$) als das Verhältnis zwischen einer Summe von Änderungen in der Nullspannung ($\Delta V_0$), multipliziert mit einem Faktor, und einer Summe der Änderungen in dem Nullstrom ($\Delta I_0$), multipliziert mit einem Faktor, geschätzt wird, und wobei die Gegenimpedanz ($Z_2$) als das Verhältnis zwischen einer Summe von Änderungen in der Gegenspannung ($\Delta$Vz), multipliziert mit einem Faktor, und einer Summe der Änderungen in dem Gegenstrom ($\Delta I_2$), multipliziert mit einem Faktor, geschätzt wird.

4. Elektrizitätszähler nach Anspruch 3, wobei der Faktor aus den Änderungen des Null- bzw. des Gegenstroms abgeleitet wird.

5. Elektrizitätszähler nach einem der Ansprüche 1 bis 4, wobei der erste Vergessensfaktor ($\rho_0$) und der zweite Vergessensfaktor ($\rho_2$) dynamische Faktoren sind, die von dem Verhältnis der Änderungen in den Sequenzströmen ($\Delta I_0$, $\Delta I_2$) zu einer summierten Stromänderung abhängen.

6. Elektrizitätszähler nach Anspruch 5, wobei die summierte Stromänderung durch einen maximalen gemessenen Stromwert des Elektrizitätszählers begrenzt ist.

7. Elektrizitätszähler nach Anspruch 6, wobei jede der Null- und Gegenimpedanz durch Folgendes geschätzt wird:

$$Z(n) = \frac{(1-\rho(n))Z_{num}(n-1)+\rho(n)\Delta V(n)\Delta I^*(n)}{(1-\rho(n))Z_{den}(n-1)+\rho(n)|\Delta I(n)|^2} \, ,$$

wobei der Vergessensfaktor ($\rho$) ein dynamischer Faktor ist, der wie folgt definiert ist:

$$\rho(n) = \frac{|\Delta I(n)|}{\min(\sum_n |\Delta I(n)|; \text{A})} \, .$$

8. Elektrizitätszähler nach einem der vorhergehenden Ansprüche, ferner umfassend ein Tiefpassfilter, das dazu eingerichtet ist, höhere Oberschwingungen der gemessenen Spannungen und Ströme herauszufiltern.

9. Elektrizitätszähler nach einem der vorhergehenden Ansprüche, ferner umfassend eine Einheit zum Empfangen eines GPS-Zeitsignals.

10. Elektrizitätszähler nach einem der vorhergehenden Ansprüche, wobei die Spannungsänderungen und Stromänderungen der Messungen über ein Zeitintervall von 5 bis 30 Sekunden gemessen werden.

11. Elektrizitätszähler nach einem der vorhergehenden Ansprüche, wobei der Elektrizitätszähler ein Kommunikationsmodul umfasst, das dazu eingerichtet ist, den Impedanzwert an einen Datensammler zu übertragen.

**12.** Verfahren zum Schätzen von Netzimpedanz in einem Verteilungsnetz mit drei Phasen, wobei das Verfahren Folgendes umfasst:

- Messen von Spannungen und Strömen für jede der drei Phasen, um die elektrische Energie für jede Phase zu berechnen, die von dem Elektrizitätsverteilungsnetz geliefert wird;
- Schätzen eines Impedanzwertes des elektrischen Netzes durch einen Impedanzlernalgorithmus, wobei der Impedanzlernalgorithmus Folgendes umfasst:

- Berechnen von Nullkomponenten und Gegenkomponenten der drei Phasen, einschließlich Null- und Gegenspannung und -strom, auf Grundlage von gemessenen Spannungen und Strömen;

**gekennzeichnet durch**

- Schätzen einer Nullimpedanz als das Verhältnis zwischen einer Summe von Änderungen der Nullspannung und einer Summe der Änderungen des Nullstromes, wobei die Summierungen von Änderungen in einem einstellbaren autoregressiven Prozess kontinuierlich aktualisiert werden; und
- Schätzen einer Gegenimpedanz als das Verhältnis zwischen einer Summe von Änderungen der Gegenspannung und einer Summe der Änderungen des Gegenstromes, wobei die Summierungen von Änderungen in einem einstellbaren autoregressiven Prozess kontinuierlich aktualisiert werden; und
- wobei der autoregressive Prozess zum Schätzen der Nullimpedanz ($Z_0$) einen ersten Vergessensfaktor ($\rho_0$) umfasst und die autoregressiven Prozesse zum Schätzen der Gegenimpedanz ($Z_2$) einen zweiten Vergessensfaktor ($\rho_2$) umfassen.

**13.** System, beinhaltend eine Vielzahl von Elektrizitätszählern nach den Ansprüchen 1 bis 11, wobei jeder zum Messen von Elektrizitätsdaten eines gelieferten Versorgungsgutes eingerichtet ist, und einen Datensammlers zum Sammeln der Elektrizitätsdaten, die Impedanzwerte beinhalten, wobei die Elektrizitätszähler und der Datensammler als Datenknoten in einem Kommunikationsnetz eingerichtet sind; wobei die Elektrizitätsdaten, die Impedanzwerte beinhalten, dazu verwendet werden, ein Netzmodell des Elektrizitätsverteilungsnetzes der Vielzahl von Elektrizitätszählern zu bilden; wobei das Netzmodell des Elektrizitätsverteilungsnetzes Informationen über das Stromverteilungsnetz bereitstellt; und wobei ein Verteilungssystembetreiber das System gemäß dem Netzmodell betreibt.

**Revendications**

**1.** Compteur d'électricité (2) adapté pour mesurer la consommation d'électricité dans un réseau de distribution d'électricité (12) à trois phases (L1, L2, L3), le compteur d'électricité comprenant :

- un circuit de mesure pour mesurer les tensions et les courants pour chacune des trois phases,
- une unité à microcontrôleur (MCU) configurée pour calculer l'énergie électrique fournie par le réseau de distribution d'électricité via les phases, et
- une unité d'algorithme d'apprentissage d'impédance destinée à être exécutée par l'unité de microcontrôleur, étant agencée pour estimer les valeurs d'impédance du réseau de distribution d'électricité telles que vues au niveau du compteur d'électricité, dans lequel l'unité d'algorithme d'apprentissage d'impédance est agencée pour :

- sur la base des tensions et courants mesurés des trois phases, calculer en continu les valeurs des tensions homopolaires et inverses ($V_0$, $V_2$) et les valeurs des courants homopolaires et inverses ($I_0$, $I_2$)

**caractérisé par**

- l'estimation d'une impédance homopolaire ($Z_0$) comme le rapport entre une somme des variations de la tension homopolaire ($\Delta V_0$) et une somme des variations du courant homopolaire ($\Delta I_0$),
- l'estimation d'une impédance inverse ($Z_2$) comme le rapport entre une somme des variations de la tension inverse ($\Delta Vz$) et une somme des variations du courant inverse ($\Delta I_2$)

dans lequel les sommes des variations des tensions et courants homopolaires et inverses sont mises à jour en continu dans un processus autorégressif réglable et

dans lequel le processus auto-régressif pour estimer l'impédance homopolaire ($Z_0$) comprend un premier facteur d'oubli ($\rho_0$), et les processus auto-régressifs pour estimer l'impédance inverse ($Z_2$) comprennent

un deuxième facteur d'oubli ($\rho_2$).

2. Compteur d'électricité selon la revendication 1, l'unité d'algorithme d'apprentissage d'impédance étant en outre agencée pour estimer l'impédance inverse ($Z_2$) et l'impédance homopolaire ($Z_0$) en utilisant des algorithmes des moindres carrés, en particulier des algorithmes des moindres carrés minimum.

3. Compteur d'électricité selon l'une quelconque des revendications précédentes, dans lequel l'impédance homopolaire ($Z_0$) est estimée comme le rapport entre une somme des variations de la tension homopolaire ($\Delta V_0$) multipliée par un facteur et une somme des variations du courant homopolaire ($\Delta I_0$) multipliée par un facteur, et dans lequel l'impédance inverse ($Z_2$) est estimée comme le rapport entre une somme des variations de la tension inverse ($\Delta Vz$) multipliée par un facteur et une somme des variations du courant inverse ($\Delta I_2$) multipliée par un facteur.

4. Compteur d'électricité selon la revendication 3, dans lequel le facteur est dérivé des variations des courants homopolaire et inverse, respectivement.

5. Compteur d'électricité selon l'une quelconque des revendications 1 à 4, dans lequel le premier facteur d'oubli ($\rho_0$) et le deuxième facteur d'oubli ($\rho_2$) sont des facteurs dynamiques dépendant du rapport des variations des courants de séquence ($\Delta I_0$, $\Delta I_2$) à une variation de courant cumulée.

6. Compteur d'électricité selon la revendication 5, dans lequel la variation de courant cumulée est limitée par une valeur de courant maximale mesurée du compteur d'électricité.

7. Compteur d'électricité selon la revendication 6, dans lequel chacune des impédances homopolaires et inverses sont estimées par :

$$Z(n) = \frac{(1-\rho(n))Z_{num}(n-1)+\rho(n)\Delta V(n)\Delta I^*(n)}{(1-\rho(n))Z_{den}(n-1)+\rho(n)|\Delta I(n)|^2} \ ,$$

dans lequel le facteur d'oubli ($\rho$) est un facteur dynamique défini comme :

$$\rho(n) = \frac{|\Delta I(n)|}{\min(\sum_n|\Delta I(n)|;A)} \ .$$

8. Compteur d'électricité selon l'une quelconque des revendications précédentes, comprenant en outre un filtre passe-bas, agencé pour filtrer les harmoniques supérieures des tensions et courants mesurés.

9. Compteur d'électricité selon l'une quelconque des revendications précédentes, comprenant en outre une unité pour recevoir un signal horaire GPS.

10. Compteur d'électricité selon l'une quelconque des revendications précédentes, dans lequel les variations de tension et les variations de courant des mesures sont mesurées sur un intervalle de temps de 5 à 30 secondes.

11. Compteur d'électricité selon l'une quelconque des revendications précédentes, dans lequel le compteur d'électricité comprend un module de communication agencé pour transmettre la valeur d'impédance à un collecteur de données.

12. Procédé d'estimation d'impédance de réseau dans un réseau de distribution à trois phases, le procédé comprenant :

- la mesure des tensions et des courants pour chacune des trois phases, afin de calculer l'énergie électrique pour chaque phase fournie par le réseau de distribution d'électricité ;
- l'estimation d'une valeur d'impédance du réseau électrique par un algorithme d'apprentissage d'impédance, dans lequel l'algorithme d'apprentissage d'impédance comprend :

- le calcul des composantes homopolaires et des composantes inverses, y compris les tensions et courants homopolaires et inverses, des trois phases, sur la base des tensions et courants mesurés ;

**caractérisé par**

- l'estimation d'une impédance homopolaire comme le rapport entre une somme des variations de la tension homopolaire et une somme des variations du courant homopolaire, dans lequel les sommes des variations sont mises à jour en continu dans un processus auto-régressif réglable ; et

- l'estimation d'une impédance inverse comme le rapport entre une somme des variations de la tension inverse et une somme des variations du courant inverse, dans lequel les sommes des variations sont mises à jour en continu dans un processus autorégressif réglable et

- dans lequel le processus auto-régressif pour estimer l'impédance homopolaire ($Z_0$) comprend un premier facteur d'oubli ($\rho_0$), et les processus auto-régressifs pour estimer l'impédance inverse ($Z_2$) comprennent un deuxième facteur d'oubli ($\rho_2$).

13. Système comprenant une pluralité de compteurs d'électricité selon les revendications 1 à 11, chacun étant agencé pour mesurer les données d'électricité d'un fournisseur d'énergie et un collecteur de données pour collecter les données d'électricité, y compris les valeurs d'impédance, les compteurs d'électricité et le collecteur de données étant agencés en tant que noeuds de données dans un réseau de communication ; dans lequel les données d'électricité, y compris les valeurs d'impédance, sont utilisées pour former un modèle de réseau du réseau de distribution d'électricité de la pluralité de compteurs d'électricité ; le modèle de réseau du réseau de distribution d'électricité, fournissant des informations sur le réseau de distribution d'électricité ; et dans lequel un opérateur de système de distribution exploite le système selon le modèle de réseau.

Figure 1

Figure 2

Figure 3

Figure 4

Figure 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008204054 A1